**Europäisches Patentamt**

**European Patent Office**

**Office européen des brevets**

(19)

(11) Veröffentlichungsnummer : **0 470 209 B1**

(12) # EUROPÄISCHE PATENTSCHRIFT

(45) Veröffentlichungstag der Patentschrift :
30.12.92 Patentblatt 92/53

(51) Int. Cl.$^5$ : **H01J 27/22, H01J 37/08**

(21) Anmeldenummer : **90912792.0**

(22) Anmeldetag : **31.08.90**

(86) Internationale Anmeldenummer :
**PCT/DE90/00666**

(87) Internationale Veröffentlichungsnummer :
**WO 91/06969 16.05.91 Gazette 91/11**

(54) **METALLIONENQUELLE UND VERFAHREN ZUM ERZEUGEN VON METALLIONEN.**

(30) Priorität : **24.10.89 DE 3935408**

(43) Veröffentlichungstag der Anmeldung :
**12.02.92 Patentblatt 92/07**

(45) Bekanntmachung des Hinweises auf die
Patenterteilung :
**30.12.92 Patentblatt 92/53**

(84) Benannte Vertragsstaaten :
**DE GB**

(56) Entgegenhaltungen :
**EP-A- 94 473
PATENT ABSTRACTS OF JAPAN, Vol. 8, No.
281 (E-286)(1718), 21 December 1984, & JP-A-59
PATENT ABSTRACTS OF JAPAN, Vol. 7, No.
123 (E-178)(1268), 27 May 1983, & JP-A-58
42150**

(73) Patentinhaber :
**FRAUNHOFER-GESELLSCHAFT ZUR
FÖRDERUNG DER ANGEWANDTEN
FORSCHUNG E.V.
Leonrodstrasse 54
W-8000 München 19 (DE)**
(84) **DE GB**
Patentinhaber : **Siemens Aktiengesellschaft
Wittelsbacherplatz 2
W-8000 München 22 (DE)**
(84) **DE**

(72) Erfinder : **KLUGE, Andreas
Schedelstrasse 23
W-8500 Nürnberg (DE)**
Erfinder : **NELLE, Peter
Korbinianstrasse 37
W-8000 München 40 (DE)**

(74) Vertreter : **Schoppe, Fritz, Dipl.-Ing. et al
Seitnerstrasse 42
W-8023 Pullach bei München (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Die vorliegende Erfindung bezieht sich auf eine Metallionenquelle mit einer mit Gas gefüllten Ionenkammer zum Erzeugen von Gasionen, die auf ein Metallteil aus dem zur Abgabe der Metallionen bestimmten Metall beschleunigt werden und bei ihrem Auftreffen auf das Metallteil Metallatome aus diesem herauslösen, welche ihrerseits ionisiert werden.

Gleichfalls bezieht sich die Erfindung auf ein Verfahren zum Erzeugen vom Metallionen, welches insbesondere für die Ionenimplantation in Halbleiterwafern zur Herstellung von dotierten Halbleiterstrukturen dient, bei dem zunächst Gasionen erzeugt werden, sodann diese auf ein Metallteil aus dem zu Abgabe der Metallionen bestimmten Metall beschleunigt werden, woraufhin bei dem Auftreffen der Gasionen auf das Metallteil Metallatome aus diesem herausgelöst werden, die dann ihrerseits ionisiert werden.

In der Halbleitertechnik werden beispielsweise zum Aufbringen vom Metall auf die Oberflächen von Halbleiterwafern sogenannte Sputterquellen eingesetzt. Dieses durch Sputtern auf die Oberfläche eines Halbleiterwafers aufgebrachte Metall, bei dem es sich beispielsweise um Gold oder Platin handeln kann, wird nach dem Aufbringen auf die Oberfläche in den Halbleiterkörper eindiffundiert, um eine bestimmte Dotierung und somit eine bestimmte Herabsetzung der Lebensdauer von Minoritätsträgern zu erzielen.

Bei einer bekannten Sputterquelle werden zunächst innerhalb einer Ionenkammer Argonionen innerhalb eines ersten elektrischen Feldes erzeugt. Ein Target aus dem zur Abgabe der Metallionen bestimmten Metall liegt in einer abgetrennten Struktur innerhalb der Ionenkammer und wird mit einem eigenen Potential zur Erzeugung eines getrennten elektrischen Feldes beaufschlagt, innerhalb dessen die Gasionen auf das Target zum Auslösen von Metallatomen beschleunigt werden. Auch die anschließende Ionisation und Nachbeschleunigung der abgesputterten Metallatome findet in einem eigenen elektrischen Feld statt, das unabhängig von dem elektrischen Feld zur Ionisation des Argongases ist.

Die bekannte Metallionenquelle in Form der oben beschriebenen Sputterquelle ist dahingehend als nachteilig anzusehen, daß sie über wenigstens zwei voneinander unabhängige Hochspannungsquellen verfügen muß, so daß die bekannte Metallionenquelle bereits aus diesem Grunde technisch wie finanziell aufwendig ist. Ferner müssen wenigstens zwei getrennte Elektrodenzuführungen mit entsprechenden Isolationsvorrichtungen vorgesehen sein, bei denen es sich im Falle der Metallionenquellen der in Rede stehenden Art um aufwendige Keramikisolationsvorrichtungen handeln muß. Auch aus diesem Grunde ist die bekannte Metallionenquelle nötigerweise aufwendig und kostspielig. Ferner erweist es sich bei der bekannten Metallionenquelle als schwierig, Implantationen von sehr kleinen Metalldosen in der Größenordnung von $10^{14}$ cm$^2$ vorzunehmen, wie sie für die Lebensdauerdotierung von Halbleitern benötigt werden.

Ferner sind Metallverdampfungsverfahren und Metallverdampferquellen bekannt, mit denen Metall auf einen zu bedampfenden Körper aufgebracht werden kann. Beispiele dieser Technologien sind beschrieben in der DE PS 2827647, der DE-AS 2521536, der DE-AS 2364379 sowie der DE-OS 1765636. Bei der Verdampfertechnik nach der letztgenannten Schrift zum Stand der Technik wird ein Stab des zu verdampfenden Metallteiles in der Nähe einer Heizwendel angeordnet, wobei ein hohes Gleichspannungspotential zwischen der Heizwendel und dem Stab des zu verdampfenden Gutes eingesetzt wird. Derartige Verdampfertechnologien eignen sich jedoch weder für die Implantation sehr geringer Metalldosen in der oben genannten Größenordnung, noch können sie für alle Verbindungen eingesetzt werden, da es beispielsweise bei dem Metall Platin an geeigneten Verbindungen fehlt, um dieses bei den Temperaturen innerhalb einer Verdampferquelle von etwa 800°C mit genügend hohem Dampfdruck verdampfen zu lassen.

Aus Patent Abstracts of Japan vol. 8 no. 281 (E 286) (1984) und aus der JP-A-59 149 643 ist bereits eine Ionenquelle mit einer Ionenkammer, einer elektrisch beheizbaren Glühkathode in Form eines Heizdrahtes, einer Annode und einem Target zur Abgabe der Ionen bekannt. Das Target aus dem abzusputternden Material bewirkt eine starke Abschirmwirkung des Elektronenflusses und verursacht dadurch einen niedrigen Wirkungsgrad der Ionenquelle. Das Target besteht bei dieser bekannten Ionenquelle aus Berylliumoxid. Aufgrund des schlechten elektrischen Leitvermögens von Berylliumoxid hat die Oberfläche des Targets kein definiertes Potential.

Der vorliegenden Erfindung liegt daher die Aufgabe zugrunde, eine Metallionenquelle der eingangs genannten Art so weiterzubilden, daß diese eine vereinfachte Struktur hat.

Die Aufgabe wird durch eine Metallionenquelle mit den in dem Patentanspruch 1 angegebenen Merkmalen gelöst.

Der Erfindung liegt die Erkenntnis zugrunde, daß bei Anordnung der als Heizdraht ausgebildeten Glühkathode in der Ionenkammer in Nachbarschaft zu dem Metallteil, das zur Abgabe der Metallionen bestimmt ist, eine erhebliche Vereinfachung und Verbesserung der eingangs geschilderten Metallionenquelle nach dem Stand der Technik, die nach dem Sputterverfahren arbeitet, erzielbar ist. Die erfindungsgemäße Metallionenquelle arbeitet für die Erzeugung der Gasionen, für das Beschleunigen der Gasionen auf das zur Abgabe der Metallionen bestimmte Metallteil und für das anschließende Ionisieren der herausgelösten Metallatome mit einem einzigen elektrischen Feld, das zwischen der als Heizdraht ausgebildeten Glühkathode und einer Anode erzeugt wird, die durch die Wandung der Ionenkammer gebildet sein kann. Hierdurch entfällt beim Gegenstand der Erfindung das Erfordernis zweier getrennter Hochspannungsquellen für die Potentialbeaufschlagung zweier Elektroden, wie dies bei der eingangs erläuterten Metallionenquelle nach dem Stand der Technik der Fall ist. Dementsprechend sind die Isolationsdurchführungen für die Kathode bei der erfindungsgemäßen Metallionenquelle auch deutlich einfacher als die Isolationsdurchführungen für die Elektroden bei der bekannten Metallionenquelle.

Das erfindungsgemäße Verfahren zum Erzeugen von Metallionen arbeitet mit einem einzigen elektrischen Feld für die Elektronenemission aus der Glühkathode in Form des Heizdrahtes, für die Gasionisation, für die Beschleunigung der Gasionen und für das anschließende Ionisieren der ausgelösten Metallatome und für das Nachbeschleunigen der Metallionen. Innerhalb dieses einzigen elektrischen Feldes für die oben genannten Zwecke werden also zunächst Elektronen aus der Glühkathode zum Ionisieren des Gases emittiert. Die emittierten Elektronen werden in diesem elektrischen Feld beschleunigt, um nach Durchlaufen der mittleren freien Wegstrecke das Gas zu ionisieren. Die so erzeugten Gasionen werden ihrerseits in diesem elektrischen Feld auf das Metallteil hin beschleunigt. Die aus dem Metallteil ausgelösten Metallatome werden mittels der von der heizdrahtförmigen Glühkathode emittierten Elektronen ionisiert. Die so gebildeten Metallionen werden unter der Wirkung dieses elektrischen Feldes beschleunigt. Im Gegensatz zu dem Metallionenerzeugungsverfahren nach dem Stand der Technik, bei dem der verfahrensmäßige Ablauf der Gasionenerzeugung völlig getrennt von demjenigen der Metallionenerzeugung ist, ist das erfindungsgemäße Metallionenerzeugungsverfahren ein einheitlicher Prozeß, der im Gegensatz zu dem Verfahren nach dem Stand der Technik weder separate Felder noch eine ablaufmäßige Trennung von unterschiedlichen Verfahrensschritten voraussetzt.

Besondere Bedeutung kommt dem erfindungsgemäßen Metallionenerzeugungsverfahren für die Implantation niedriger Dosen von Dotierungsmetallen, wie beispielsweise Platin, zu. Das erfindungsgemäße Implantationsverfahren unter Verwendung des erfindungsgemäßen Metallionenerzeugungsverfahrens erlaubt eine genaue Steuerbarkeit der durch Metallionenimplantation erzielten Dotierung.

Bevorzugte Weiterbildungen der erfindungsgemäßen Metallionenquelle und des erfindungsgemäßen Metallerzeugungsverfahrens sind in den Unteransprüchen angegeben.

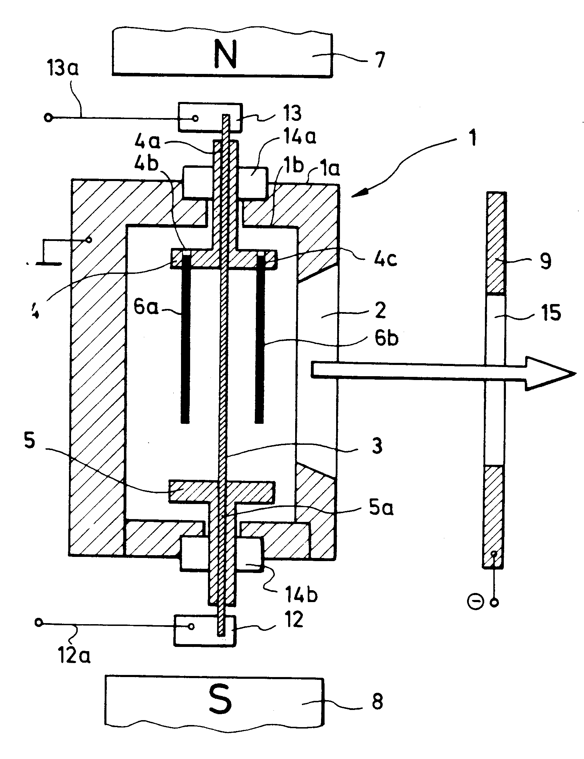

Nachfolgend werden unter Bezugnahme auf die beiliegende Zeichnung ein bevorzugtes Ausführungsbeispiel der erfindungsgemäßen Metallionenquelle und eine bevorzugte Ausführungsform des erfindungsgemäßen Metallionenerzeugungsverfahrens näher erläutert. Es zeigen:

Die einzige Figur eine Schnittdarstellung durch ein Ausführungsbeispiel der erfindungsgemäßen Metallionenquelle.

Die Ionenquelle, die in ihrer Gesamtheit mit dem Bezugszeichen 1 bezeichnet ist, umfaßt eine Ionenkammer 1a mit einer leitfähigen, vorzugsweise aus einem Edelstahl bestehenden Kammerwandung 1b. Die Kammerwandung 1b ist geerdet und bildet, wie später verdeutlicht wird, die Anode der Ionenquelle 1. Auf einer Seite weist die Ionenkammer 1a eine Austrittsöffnung 2 auf, durch die, wie später näher erläutert wird, Metallionen austreten können. Durch die Ionenkammer 1a erstreckt sich eine elektrisch beheizbare Glühkathode in Form eines Heizdrahtes 3, der bei dem bevorzugten Ausführungsbeispiel aus Wolfram besteht. Der Heizdraht 3 wird über Anschlußelektroden 12, 13 mit einem Heizstrom versorgt, der ausreichend stark ist, um den Heizdraht 3 glühen zu lassen. Die Zuleitungen 12a, 13a, die Elektroden 12, 13 und der hieran angeschlossene Heizdraht 3 sind gegenüber der leitfähigen Kammerwandung 1b der Ionenkammer 1a durch Keramikisolierringe 14a, 14b isoliert. Die Keramikisolierringe liegen an ihrer Innenseite an je einem Elektronenreflektor 4, 5 an. Die Elektronenreflektoren bestehen aus einem leitfähigen Material, wobei hierfür vorzugsweise Edelstahl verwendet wird. Die Elektronenreflektoren 4, 5 weisen ihrerseits eine Innenbohrung 4a, 5a auf. Der Heizdraht 3 wird von den Innenbohrungen 4a, 5a der Elektronenreflektoren 4, 5 fest umschlossen und steht mit diesen in elektrisch leitendem Kontakt. Die Elektroden 12 bzw. 13 werden mit einem gegenüber dem Massepotential der leitfähigen Kammerwandung 1b negativen Potential zum Erzeugen eines elektrischen Feldes zwischen der Glühkathode und der durch die Kammerwandung 1b gebildeten Anode beaufschlagt. Die Spannung zwischen der Anode und der Glühkathode ist, wie nachfolgend näher erläutert wird, so hoch gewählt, daß sich eine Glimmentladung innerhalb der Ionenkammer 1a einstellt.

Ein Metallteil 6, das aus dem zur Abgabe der Metallionen bestimmten Metall besteht, liegt im wesentlichen auf demselben Potential wie die Elektronenreflektoren 4, 5 und somit der Heizdraht 3. Bei dem bevorzugten Ausführungsbeispiel umfaßt das Metallteil 6 wenigstens zwei Metalldrähte 6a, 6b, die sich parallel zu dem Heizdraht 3 erstrecken und in Bohrungen 4b, 4c eines der beiden Elektronenreflektoren 4 durch Pressitz gehalten sind.

Die Ionenkammer 1a ist mit einem ionisierbaren Gas gefüllt, das bei dem bevorzugten Ausführungsbeispiel Argon ist. Jedoch kann, wie für den Fachmann offensichtlich ist, auch ein anderes ionisierbares Gas eingesetzt werden, wobei insbesondere auch Chlor in Betracht kommt.

Oberhalb und unterhalb der Ionenkammer 1a liegen die Magnetpole 7, 8 einer Magnetfelderzeugungsvorrichtung, die ein die Ionenkammer 1a parallel zum Heizdraht 3 durchsetzendes magnetisches Feld erzeugt.

Außerhalb der Ionenkammer 1a liegt eine Extraktionselektrode 9 mit einer Elektrodenöffnung 15, die mit einem negativen Potential beaufschlagt ist.

Ein wesentlicher Aspekt der erfindungsgemäßem Metallionenquelle besteht darin, daß das zur Abgabe der Metallionen bestimmte Metallteil 6a, 6b derart benachbart zum dem Heizdraht 3 angeordnet ist, daß das Metallteil 6a, 6b durch den Heizdraht 3 erwärmt wird. Durch diese erzwungene Erwärmung des Metallteiles 6, das beispielsweise die Form von Metalldrähten 6a, 6a bei dem gezeigten Ausführungsbeispiel haben kann, werden Kontaminationen an der Oberfläche des Metallteiles 6 beseitigt, wodurch das Absputtern des Metalles verbessert wird.

Gleichfalls besteht ein wesentlicher Aspekt der Erfindung darin, daß sich das Metallteil im wesentlichen auf dem Potential des Heizdrahtes 3 befindet. Bevorzugt ist das Metallteil 6 leitend mit dem Heizdraht verbunden. Es ist jedoch auch möglich, eine bezogen auf die Spannung zwischen dem Heizdraht 3 und der Kammerwandung 1b kleine Potentialdifferenz zwischen dem Heizdraht 3 und dem Metallteil 6 zuzulassen.

Die erfindungsgemäße Ionenquelle 1 arbeitet gemäß dem nachfolgend erläuterten Metallionenerzeugungsverfahren. In einem ersten Verfahrensschritt wird der Heizdraht 3 auf eine hohe Temperatur von etwa 2000°C, die jedoch unterhalb seiner Schmelztemperatur liegt, durch entsprechende Stromzufuhr aufgeheizt. Durch Anlegen einer geeigneten Spannung zwischen dem Heizdraht 3, der als Glühkathode arbeitet, und der Kammerwandung 1b der Ionenkammer 1a, die als Anode arbeitet, wird ein einziges elektrisches Feld innerhalb der Ionenkammer 1a erzeugt. In diesem elektrischen Feld werden die aus der Glühkathode in Form des Heizdrahtes 3 auftretenden Elektronen zunächst in radialer Richtung beschleunigt, wobei sie aufgrund des senkrecht ihren anfänglichen Laufweg durchsetzenden magnetischen Feldes zu einer schraubenförmigen Bewegung von der Glühkathode in Form des Heizdrahtes 3 zu der Anode in Form der Kammerwandung 1b gezwungen werden. Für den Fachmann ist offensichtlich, daß das Magnetfeld allein dazu dient, die von den Elektronen durchlaufene Weglänge zwischen der Glühkathode und der Kammerwandung gegenüber deren radialen Abstand zu erhöhen, um dadurch die Anzahl der Gasionenbildungen zu erhöhen. Es ist also bei Inkaufnahme einer niedrigeren Ausbeute möglich, die erfindungsgemäße Ionenquelle 1 auch ohne Magnetfeld zu betreiben. Die durch Auftreffen der Elektronen auf die Argonatome erzeugten Argonionen werden durch das elektrische Feld in einer bezogen auf die mittlere Bewegungsrichtung der Elektronen umgekehrten Richtung beschleunigt. Diejenigen Argonionen, die auf die Metalldrähte 6a, 6b auftreffen, lösen aus diesen Metallatome aus. Die bei dem bevorzugten Ausführungsbeispiel auf diese Weise erzeugten Platinatome werden durch die von dem Heizdraht 3 emittierten Elektronen ionisiert.

Die positiv geladenen Platinionen, die auf diese Weise in dem einzigen elektrischen Feld, das die erfindungsgemäße Ionenkammer 1a durchsetzt, erzeugt werden, werden durch dieses bezogen auf den Heizdraht 3 in radialer Richtung nach außen beschleunigt, wobei die durch die Austrittsöffnung 2 ausgetretenen Platinionen durch das von der Extraktionselektrode 9 erzeugte Feld nachbeschleunigt werden. Somit erzeugt die Ionenquelle 1 einen Platinionenstrom in Richtung des in der Fig. angedeuteten Pfeiles.

Der Platinionenstrahl wird einer Selektion gemäß dem Verhältnis des Gewichtes der Ladung der Ionenstrahlteilchen unterworfen, einer weiteren Nachbeschleunigungseinheit zugeführt und fokussiert. Eine (nicht dargestellte) elektrostatische Ablenkeinheit sorgt für eine gleichmäßge Bestrahlung einer Halbleiterwaferscheibe, in die die Metallionen zu implantieren sind. Das erfindungsgemäße Implantationsverfahren findet vorzugsweise Einsatz für die Implantation kleiner Metalldosen in Halbleiterstrukturen bei Dosen von einigen $10^{12}$ Atomen cm$^2$ min$^1$.

## Patentansprüche

1.  Metallionenquelle mit einer mit einem Gas gefüllten Ionenkammer (1a) zum Erzeugen von Gasionen, einer in der Ionenkammer (6) angeordneten, elektrisch beheizbaren Glühkathode in Form eines Heizdrahtes (3), einer Anode (1b) und einem aus dem zur Abgabe der Metallionen bestimmten Metall bestehenden Metallteil (6), auf das im Betrieb Gasionen auftreffen und Metallatome aus diesem herauslösen, welche ihrerseits ionisiert werden,

    wobei der Heizdraht (3) und das Metallteil (6) auf dem gleichen Potential liegen oder eine bezogen auf die Spannung zwischen dem Heizdraht (3) und der Anode (1b) nur geringe Potentialdifferenz haben,

    wobei der Heizdraht (3) derart benachbart zu dem Metallteil (6) angeordnet ist, daß dieses durch den Heizdraht (3) erwärmt wird, und

    wobei das Metallteil (6) länglich ist und sich im wesentlichen parallel zu dem Heizdraht (3) mit einem im wesentlichen gleichbleibenden radialen Abstand von diesem erstreckt.

2. Metallionenquelle nach Anspruch 1,
dadurch gekennzeichnet,
daß das Metallteil (6) mit dem Heizdraht (3) elektrisch verbunden ist.

3. Metallionenquelle nach Anspruch 1 oder 2,
dadurch gekennzeichnet,
daß sich der Heizdraht (3) zwischen zwei aus einem leitfähigen Material bestehenden Elektronenreflektoren (4, 5) erstreckt, von denen wenigstens einer (4) zur Halterung des Metallteiles (6) ausgebildet ist.

4. Metallionenquelle nach einem der Ansprüche 1 bis 3,
dadurch gekennzeichnet,
daß das Metallteil als Metalldraht (6a, 6b) ausgebildet ist.

5. Metallionenquelle nach einem der Ansprüche 1 bis 4,
dadurch gekennzeichnet,
daß das Gas Argon oder Chlor und das Metall des Metallteiles (6) Platin ist.

6. Verfahren zum Betrieb der Metallionenquelle nach einem der Ansprüche 1 bis 5, insbesondere für die Implantation von Metallionen in Halbleiterwafer zur Herstellung von dotierten Halbleiterstrukturen, bei dem zwischen der Glühkathode (3) und der Anode (1b) eine derartige Spannung angelegt wird, daß ein einziges elektrisches Feld erzeugt wird, das die Gasionen so beschleunigt, daß sie Metallatome aus dem Metallteil herauslösen und daß die herausgelösten Metallatome ionisiert werden.

7. Verfahren nach Anspruch 6,
gekennzeichnet durch folgende zusätzliche Verfahrensschritte:
- Nachbeschleunigen der Metallionen;
- Durchführen einer Selektion des Metallionenstromes nach dem Verhältnis Masse zu Ladung;
- Fokussieren des Metallionenstrahles; und
- elektrostatisches oder magnetisches Ablenken des Metallionenstrahles zum gleichmäßigen Bestrahlen der zu implantierenden Halbleiterwaferscheibe.

## Claims

1. A metal-ion source comprising an ion chamber (1a) filled with a gas and used for producing gas ions, an electrically heatable thermionic cathode in the form of a heating wire (3) arranged in the ion chamber (1a), an anode (1b) and a metal component (6), which consists of the metal intended to emit the metal ions and onto which gas ions will impinge, when the metal-ion source is in operation, said gas ions detaching from said metal component metal atoms, which, in turn, will be ionized,
said heating wire (3) and said metal component (6) being at the same potential or showing a potential difference which is only small relative to the voltage between the heating wire (3) and the anode (1b),
said heating wire (3) being arranged adjacent the metal component (6) in such a way that the latter will be heated by said heating wire (3), and
said metal component (6) having an elongate shape and extending essentially parallel to the heating wire (3) at a substantially uniform radial distance therefrom.

2. A metal-ion source according to claim 1,
characterized in that
the metal component (6) is electrically connected to the heating wire (3).

3. A metal-ion source according to claim 1 or 2,
characterized in that
the heating wire (3) extends between two electron reflectors (4, 5), which consist of a conductive material and at least one (4) of which is constructed such that it is adapted to support the metal component (6).

4. A metal-ion source according to one of the claims 1 to 3,
characterized in that
the metal component consists of a metal wire (6a, 6b).

5. A metal-ion source according to one of the claims 1 to 4,
characterized in that
the gas is argon or chlorine and that the metal of the metal component (6) is platinum.

6. A process for operating the metal-ion source according to one of the claims 1 to 5, especially for implanting metal ions into semiconductor wafers for producing doped semiconductor structures, including the step of applying between the thermionic cathode (3) and the anode (1b) a voltage of such a nature that a single electric field will be generated, which will accelerate the gas ions such that they will detach metal atoms from the metal component and that the detached metal atoms will be ionized.

7. A process according to claim 6,

characterized by the following additional steps:
- post-accelerating the metal ions;
- carrying out a selection of the metal-ion current according to the ratio of mass to charge;
- focussing the metal-ion beam; and
- electrostatically or magnetically deflecting the metal-ion beam for uniformly irradiating the semiconductor wafer to be implanted.

**Revendications**

1. Source d'ions métalliques avec une chambre à ions (1a) remplie d'un gaz pour la production d'ions gazeux, une cathode incandescente pouvant être chauffée électriquement, sous forme d'un fil chauffant (3), disposée dans la chambre à ions (6), une anode (1b) et une partie métallique (6) réalisée dans le métal destiné au dégagement des ions métalliques, contre laquelle, pendant le fonctionnement, frappent des ions gazeux et de laquelle se dégagent des atomes métalliques qui sont, à leur tour, ionisés,

   le fil chauffant (3) et la partie métallique (6) se trouvant sur le même potentiel ou ne présentant qu'une faible différence de potentiel par rapport à la tension entre le fil chauffant (3) et l'anode (1b),

   le fil chauffant (3) étant disposé près de la partie métallique (6), de telle manière que celle-ci est chauffée par le fil chauffant (3), et

   la partie métallique (6) étant allongée et s'étendant sensiblement parallèlement au fil chauffant (3), à une distance radiale sensiblement constante de ce dernier.

2. Source d'ions métalliques suivant la revendication 1, caractérisée en ce que la partie métallique (6) est électriquement reliée au fil chauffant (3).

3. Source d'ions métalliques suivant la revendication 1 ou 2, caractérisée en ce que le fil chauffant (3) s'étend entre deux réflecteurs électroniques (4, 5), dont au moins l'un (4) se présente sous forme de support pour la partie métallique (6).

4. Source d'ions métalliques suivant l'une des revendications 1 à 3, caractérisée en ce que la partie métallique se présente sous forme de fil métallique (6a, 6b).

5. Source d'ions métalliques suivant l'une des revendications 1 à 4, caractérisée en ce que le gaz est de l'argon ou du chlore et que le métal de la partie métallique (6) est du platine.

6. Procédé pour la mise en oeuvre de la source d'ions métalliques suivant l'une des revendications 1 à 5, en particulier pour l'implantation d'ions métalliques dans des gauffrettes semiconductrices pour la fabrication de structures semiconductrices dotées, dans lequel il est établi, entre la cathode incandescente (3) et l'anode (1b), une tension telle qu'il est engendré un seul champ électrique qui accélère les ions gazeux de telle manière qu'ils dégagent des atomes métalliques de la partie métallique et que les atomes métalliques dégagés sont ionisés.

7. Procédé suivant la revendication 6, caractérisé par les étapes du procédé supplémentaires suivantes:
   - accélération ultérieure des ions métalliques,
   - réalisation d'une sélection du courant d'ions métalliques selon le rapport masse à charge,
   - focalisation du rayon d'ions métalliques, et
   - diffraction électrostatique ou magnétique du rayon d'ions métalliques pour l'irradiation uniforme du disque en gauffrette semiconducteur à implanter.